**Europäisches Patentamt**

**European Patent Office**

**Office européen des brevets**

(11) Numéro de publication: **0 253 741**
**B1**

(12) **FASCICULE DE BREVET EUROPEEN**

(45) Date de publication du fascicule du brevet:
19.12.90

(51) Int. Cl.⁵: **H01L 21/82, H01L 21/28**

(21) Numéro de dépôt: 87401673.6

(22) Date de dépôt: 16.07.87

(54) **Procédé de fabrication d'un circuit intégré comportant un transistor à effet de champ à doubles jonctions et un condensateur.**

(30) Priorité: 18.07.86 FR 8610493

(43) Date de publication de la demande:
20.01.88 Bulletin 88/3

(45) Mention de la délivrance du brevet:
19.12.90 Bulletin 90/51

(84) Etats contractants désignés:
DE FR GB IT NL

(56) Documents cités:
EP-A- 0 054 117
US-A- 4 541 166

PATENT ABSTRACTS OF JAPAN,
vol. 7, no. 13 (E-153)[1158], 19 janvier 1983; &
JP-A-57 172 758
IBM TECHNICAL DISCLOSURE BULLETIN,
vol. 22, no. 11, avril 1980, pages 5146-5147, New York,
US; E. BASSOUS et al.: "Self-aligned polysilicon gate
MOSFETS with tailored source and drain profiles"

(73) Titulaire: **Bois, Daniel, 9, rue de la Grange,
F-38240 Meylan(FR)**
Titulaire: **Pons, Michel, 4 Résidence Les Léchères
Avenue de la Plaine Fleurie, F-38240 Meylan(FR)**

(72) Inventeur: **Bois, Daniel, 9, rue de la Grange,
F-38240 Meylan(FR)**
Inventeur: **Pons, Michel, 4 Résidence Les Léchères
Avenue de la Plaine Fleurie, F-38240 Meylan(FR)**

(74) Mandataire: **Mongrédien, André et al, c/o
BREVATOME 25, rue de Ponthieu, F-75008 Paris(FR)**

## Description

La présente invention a pour objet un procédé de fabrication d'un circuit intégré comportant au moins un transistor à effet de champ à grille isolée, à doubles jonctions et au moins un condensateur qui peuvent être ou non reliés électriquement. Elle s'applique en particulier dans le domaine des circuits intégrés de type nMOS, pMOS et CMOS utilisés pour le traitement de signaux analogiques et dans le domaine des circuits mémoires.

Plus spécialement, l'invention se rapporte à la fabrication d'un circuit mémoire comportant un transistor commandant un condensateur servant au stockage des informations, et en particulier d'une mémoire EPROM, c'est-à-dire d'une mémoire électriquement programmable à lecture seulement effaçable par un rayonnement ultraviolet ou d'une mémoire dynamique (D.R.A.M).

Généralement, le condensateur est situé sur une zone d'isolation électrique ou oxyde de champ du circuit.

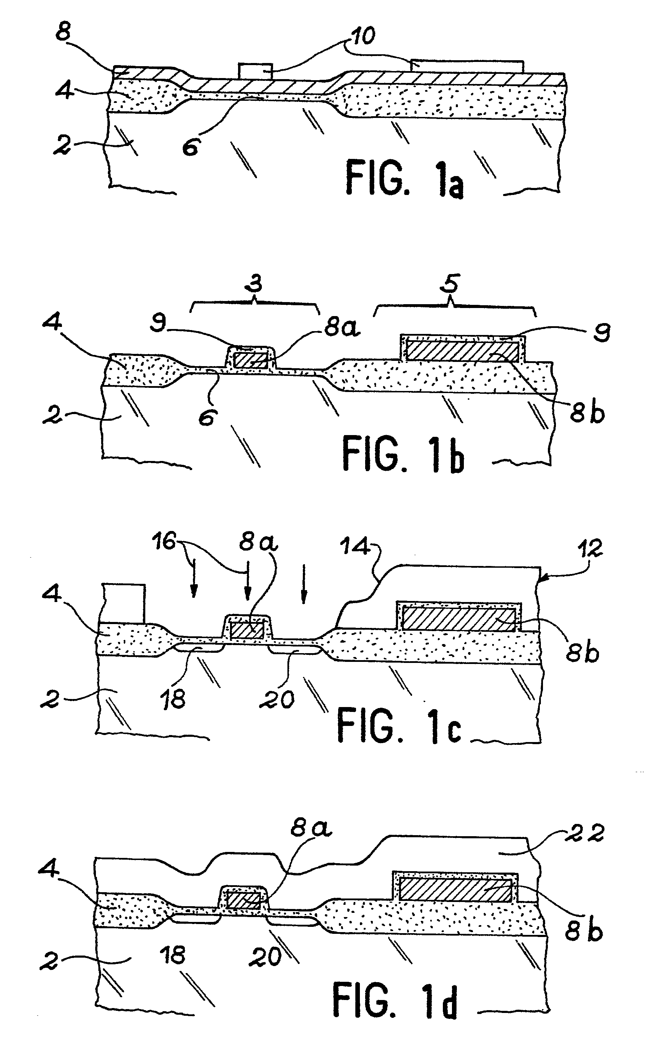

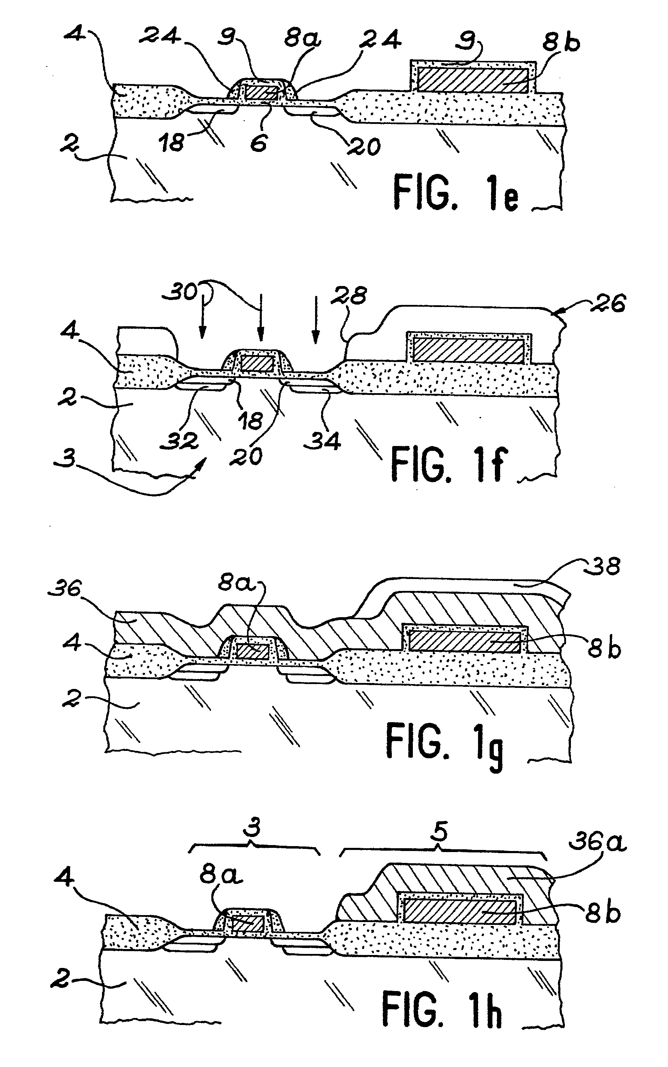

Sur les figures 1a-1h, on a représenté schématiquement, en coupe longitudinale, un procédé de fabrication connu d'un circuit intégré nMOS comportant un transistor à effet de champ à double jonction et un condensateur situé à proximité l'un de l'autre. Le transistor effet de champ porte la référence générale 3 et le condensateur la référence générale 5.

Ce procédé connu consiste, en référence à la figure 1a, à former sur un substrat en silicium 2 de type p, l'oxyde de champ 4 du circuit intégré par oxydation localisée du substrat 2 (technique LOCOS) puis à former, aussi par oxydation thermique, une mince couche d'oxyde de grille 6. L'oxyde de champ 4 présente une épaisseur d'environ 600 nm et l'oxyde de grille une épaisseur d'environ 25 nm.

L'étape suivante consiste à déposer une couche de silicium polycristallin 8 dopé de 400 nm environ d'épaisseur par la technique de dépôt chimique en phase vapeur (CVD).

On réalise ensuite par photolithographie un masque de résine 10 représentant l'image du condensateur 5 et de la grille du transistor 3 à réaliser respectivement au-dessus de l'oxyde de champ 4 et de l'oxyde de grille 6.

On élimine alors les régions de la couche de silicium 8 non recouverte de résine afin de former, comme représenté sur la figure 1b, la grille 8a du transistor, située au-dessus de l'oxyde de grille 6 et la première électrode 8b du condensateur située au-dessus de l'oxyde de champ 4. Ceci peut être réalisé par une attaque chimique, par une gravure ionique réactive ou tout autre type de gravure sèche.

Après élimination du masque de résine 10, on réalise une isolation électrique 9 de la grille 8a du transistor 3 et de la première électrode 8b du condensateur 5 en oxydant thermiquement le silicium polycristallin constituant la grille et la première électrode. Cette oxydation thermique est réalisée à une température de l'ordre de 950°C.

La partie de la couche d'isolant 9 située au-dessus de la première électrode 8b du condensateur 5 constitue le diélectrique de ce condensateur.

On réalise ensuite, comme représenté sur la figure 1c, un masque de résine 12 par photolithographie sur la structure obtenue, servant à définir l'emplacement de la source et du drain du transistor 3. En particulier, ce masque 12 présente une ouverture 14 en regard de la région du substrat dans laquelle doit être réalisé le transistor. Ce masque présente une épaisseur de 1,2 à 1,5 micromètres environ.

On effectue ensuite une implantation d'ions 16, notamment d'arsenic, afin de former, de part et d'autre de la grille 8a et dans le substrat semi-conducteur 2, deux régions 18 et 20 de type n$^+$, correspondant respectivement à la source et au drain du transistor 3. La couche de résine 12 ainsi que la grille 8a revêtue de l'isolant électrique 9 servent de masque à cette implantation ionique.

Après élimination du masque de résine 12, on dépose sur l'ensemble de la structure, comme représenté sur la figure 1d, une couche d'oxyde de silicium 22 de 500 nm environ d'épaisseur. Cette couche d'oxyde est déposée par la technique de dépôt chimique en phase vapeur, assistée ou non par plasma.

On effectue ensuite, en pleine plaque, une gravure de la couche 22 afin de former sur les flancs isolés 15 de la grille 8a des espaceurs 24, comme représenté sur la figure 1e. Cette gravure est réalisée par une technique de gravure anisotropique (gravure ionique réactive, gravure par plasma ou tout autre type de gravure sèche anisotropique). Les espaceurs 24 présentent une largeur à la base d'environ 300 nm.

On forme ensuite comme représenté sur la figure 1f, un autre masque de résine 26 identique au masque de résine 12 par photolithographie. En particulier, ce masque 26 comporte une ouverte 28 située au-dessus de la région du substrat 2 dans laquelle on réalise le transistor 3.

On effectue ensuite une implantation d'ions 30, par exemple d'arsenic, afin de former sous la source 18 et 20 du transistor deux régions respectivement 32 et 34 de type n. Ces deux régions 32 et 34 sont situées respectivement au-dessous de la source 18 et du drain 20 du transistor 3 et constituent les secondes jonctions de celui-ci.

Après élimination du masque de résine 26, on dépose une couche 36 de silicium polycristallin, comme représenté sur la figure 1g. Cette couche de silicium 36 présente une épaisseur de 400 nm environ. Elle peut être obtenue par la technique de dépôt chimique en phase vapeur.

On forme ensuite sur la couche de silicium 36, par la technique de photolithographie, un masque de résine 38, représentant l'image de la seconde électrode à réaliser du condensateur 5.

On effectue alors la gravure de la couche de silicium polycristallin 36 afin de former la seconde électrode 36a, représentée sur la figure 1h. Cette élimination est réalisée par un procédé de gravure ionique réactive ou par attaque chimique.

On élimine ensuite le masque de résine 38 puis on effectue un recuit de la structure obtenue pour guérir les défauts introduits lors des implantations.

Les étapes suivantes du procédé, non repésentées, consistent à déposer une couche d'isolant, notamment d'oxyde de silicium sur l'ensemble de la structure, à former dans celle-ci des trous de contact électrique, à déposer une couche conductrice par exemple en aluminium que l'on grave afin de former les différentes connexions du transistor 3 et du condensateur 5.

Ce procédé connu présente l'inconvénient d'être relativement complexe. En particulier il comprend plusieurs étapes de masquage (10, 12, 26, 38). Ces étapes de masquage sont relativement longues (dépôt d'une couche de résine, insolation à travers un photo-masque, développement) et posent d'importants problèmes quant au positionnement correct des masques par rapport aux couches sous-jacentes du circuit intégré.

En outre, le procédé décrit ci-dessus présente un grand nombre d'étapes.

La complexité de ce procédé augmente les risques de mauvaise fabrication et donc de circuits intégrés de mauvaise qualité électrique ainsi que le coût de ces circuits.

La présente invention a justement pour objet un nouveau procédé de fabrication d'un circuit intégré comportant au moins un transistor à effet de champ à doubles jonctions et un condensateur, situés à proximité l'un de l'autre, permettant de remédier aux différents inconvénients donnés ci-dessus.

En particulier, ce procédé permet de réduire le nombre d'étapes de masquage et de supprimer le dépôt de la couche d'isolant servant uniquement à la formation des espaceurs, de part et d'autre de la grille du transistor.

De façon plus précise, l'invention a pour objet un procédé de fabrication d'un circuit intégré dans un substrat semi-conducteur dopé, comprenant un transistor à effet de champ à doubles jonctions, formé dans une première région du substrat, et une zone d'isolation électrique formée dans une seconde région dudit substrat, adjacente à la première région, cette zone d'isolation supportant un condensateur ; ce procédé est caractérisé en ce qu'il comprend les étapes successives suivantes :

(a) - formation simultanée, dans une première couche conductrice, de la grille du transistor et d'une première électrode du condensateur,

(b) - isolation électrique simultanément de la grille et de la première électrode,

(c) - formation simultanée, dans une seconde couche conductrice, d'espaceurs sur les flancs isolés de la grille et d'une seconde électrode du condensateur,

(d) - premier dopage de la première région du substrat pour former la source et le drain du transistor, les espaceurs jouant le rôle de masque à ce premier dopage qui présente une conductivité inverse de celle du substrat,

(e) - élimination des espaceurs, et

(f) - second dopage de la première région du substrat pour former, autour de la source et du drain, deux régions de conductivité inverse de celle du substrat.

Le fait de former des espaceurs, de part et d'autre de la grille du transistor à effet de champ, ainsi que la seconde électrode du condensateur, simultanément et dans la même couche conductrice, permet une simplification importante du procédé par réduction du nombre d'étapes et en particulier du nombre de masques.

De façon préférentielle, le procédé selon l'invention comprend les étapes successives suivantes :

(1) - formation de la zone d'isolation dans la seconde région du substrat et d'un isolant de grille dans la première région dudit substrat,

(2) - formation dans la première couche conductrice de la grille du transistor et de la première électrode du condensateur,

(3) - recouvrement de toute la grille et de toute la première électrode d'une couche d'isolant électrique,

(4) - formation, dans la seconde couche conductrice, d'espaceurs sur les flancs isolés de la grille et de la seconde électrode du condensateur,

(5) - réalisation d'un masque sur l'ensemble de la structure comportant une ouverture en regard de la première région du substrat,

(6) - première implantation d'ions, à travers le masque, pour former la source et le drain du transistor, les espaceurs servant aussi de masque à cette implantation,

(7) - élimination des espaceurs,

(8) - seconde implantation d'ions, à travers ledit masque, pour former autour de la source et du drain deux régions de conductivité inverse de celle du substrat, et

(9) - élimination du masque.

Les source et drain du transistor, entourés des deux régions de conductivité inverse de celle du substrat, forment les doubles jonctions, du transistor.

Par recouvrement de toute la grille et de toute la première électrode du condensateur d'une couche isolante, il faut comprendre aussi bien le recouvrement de la surface supérieure de la grille et de l'électrode que le recouvrement de leurs flancs.

L'invention s'applique à un grand nombre de substrats semi-conducteurs tels que le silicium dopé de type n ou p, le GaAs, l'InP, le HgCdTe, etc.

En outre, les couches conductrices peuvent être réalisées en un grand nombre de matériaux comme par exemple le silicium polycristallin, les métaux réfractaires tels que Mo, Ti, Ta, W et leurs siliciures.

De même, les isolations électriques peuvent être réalisées en un grand nombre d'isolants tels que l'oxyde de silicium, le nitrure de silicium, le sulfure de zinc, etc.

Toutefois, l'invention s'applique avantageusement au circuit intégré MIS ou MOS utilisant comme substrat du silicium monocristallin, comme couches conductrices des couches en silicium polycristallin dopé n ou p et comme couches isolantes des couches d'oxyde de silicium ou de nitrure de silicium.

Dans le cas de la grille du transistor et de la première électrode du condensateur formées dans une couche de silicium polycristallin, l'isolation électrique de cette grille et de cette première électrode peut être obtenue avantageusement par oxydation thermique du silicium constituant cette couche.

Par ailleurs, suivant le type de circuits MOS envisagé le substrat en silicium utilisé peut être de type p. Dans ces conditions, les implantations ioniques pour former les doubles jonctions du transistor à effet de champ sont réalisées avec de l'arsenic ou du phosphore. Inversement, dans le cas d'un substrat en silicium de type n, les doubles jonctions du transistor sont réalisées par implantation d'ions de bore.

D'autres caractéristiques et avantages de l'invention ressortiront mieux de la description qui va suivre, donnée à titre illustratif et non limitatif.

La description est faite en référence aux figures annexées dans lesquelles :

- les figures 1a-1h, déjà décrites, représentent schématiquement, en coupe longitudinale, les différentes étapes de fabrication, selon l'art antérieur, d'un circuit intégré comportant un transistor à effet de champ à doubles jonctions et un condensateur, et
- les figures 2a-2f représentent schématiquement, en coupe longitudinale, les différentes étapes de fabrication, selon l'invention, d'un circuit intégré comportant un transistor à effet de champ à doubles jonctions et un condensateur.

La description qui suit se rapporte à la fabrication d'un transistor à effet de champ MOS à doubles jonctions, à canal N, dans un substrat en silicium de type p. Mais bien entendu, comme on l'a dit précédemment, l'invention est d'application beaucoup plus générale. En particulier, l'invention s'applique à un transistor canal P formé dans un substrat en silicium de type n.

Les différents éléments référencés ci-après porteront les mêmes références que ceux décrits précédemment en regard des figures 1a-1h, additionnées de 100.

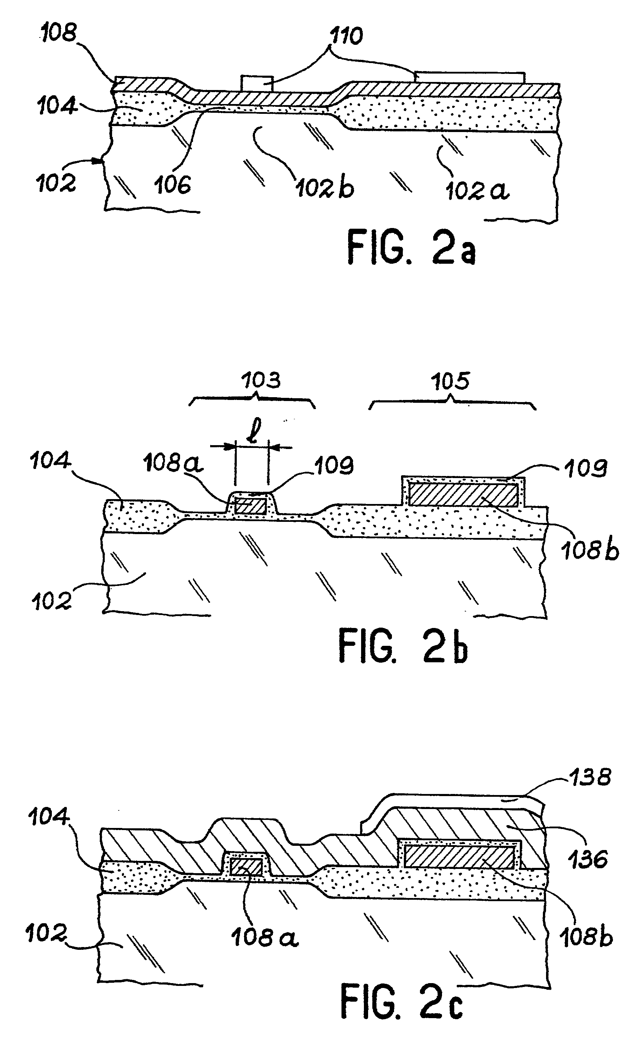

Comme pour le procédé de l'art antérieur, décrit précédemment, on forme tout d'abord sur un substrat en silicium monocristallin 102 de type p, comme représenté sur la figure 2a, un oxyde de champ 104 par oxydation localisée du substrat 102, en particulier par la technique LOCOS bien connue de l'homme de l'art. Cet oxyde de champ 104 sert à isoler électriquement les différents composants actifs du circuit intégré. Il présente une épaisseur de 600 nm environ.

La région du substrat dans laquelle est formé l'oxyde de champ porte la référence 102a et la région dans laquelle est formé le transistor à effet de champ du circuit intégré porte la référence 102b. Les régions 102a et 102b sont juxtaposées.

Après formation de l'oxyde de champ 104, on réalise dans la région 102b du substrat, dans laquelle sera réalisé ultérieurement le transistor à effet de champ 103, une mince couche d'oxyde de silicium 106, correspondant à l'oxyde de grille du transistor. Cet oxyde de grille est formé par oxydation thermique de la région 102b du substrat, à une température de l'ordre de 950°C, pendant 20 min environ. Il présente une épaisseur de 25nm environ.

On dépose ensuite sur l'ensemble de la structure une couche conductrice 108 notamment en silicium polycristallin dopé avec des dopants de conductivité inverse de celle du substrat, et en particulier avec des atomes de phosphore avec 5 à 15% en poids de phosphore. Cette couche conductrice 108 dopée n est déposée par la technique de dépôt chimique en phase vapeur à basse température (450°C) par pyrolyse de SiH₄. Cette couche 108 présente une épaisseur de 400 nm environ.

On forme ensuite sur la couche de silicium 108, par photolithographie, un masque de résine positive 110 représentant l'image de la grille du transistor et de la première électrode du condensateur à former simultanément dans la couche 108.

On effectue alors, comme représenté sur la figure 2b, une gravure de la couche 108 afin de former la grille 108a du transistor 103 et la première électrode 108b du condensateur 105, en utilisant la résine 110 comme masque à cette gravure. L'élimination des régions de la couche 108 non recouvertes de résine peut être réalisée par une gravure ionique réactive en utilisant un plasma d'hexafluorure de soufre ou tout autre gravure par plasma ou sèche ayant des caractéristiques d'anisotropie élevée. La grille 108a obtenue présente une largeur $l$ de moins de 3 micromètres.

Après élimination du masque de résine 110 avec une cétone, on forme une isolation électrique 109 de la grille 108a du transistor et de l'électrode 108b du condensatur. Cette isolation électrique 109 est réalisée par oxydation thermique du silicium polycristallin constituant la grille 108a et l'électrode 108b du condensateur. Cette oxydation peut être réalisée à 950°C pendant 30 min environ. L'isolation électrique 109 présente une épaisseur de 30 à 40 nm environ. Elle constitue en particulier le diélectrique du condensateur.

L'étape suivante du procédé consiste, comme représenté sur la figure 2c, à déposer sur l'ensemble de la structure une couche conductrice 136 dans laquelle sera réalisée ultérieurement la seconde électrode du condensateur. Cette couche 136 présente une épaisseur de 400 nm et est réalisée en silicium polycristallin éventuellement dopé de type n. Cette couche 136 est déposée par la technique de dépôt chimique en phase vapeur à basse pression (LTO) par pyrolyse du silane à une température de 450°C environ.

On forme ensuite un masque de résine 138 représentant l'image de la seconde électrode du condensateur à réaliser.

Le masque de résine 138 est réalisé par les procédés classiques de photolithographie, photorépétition ou par tout autre procédé lithographique.

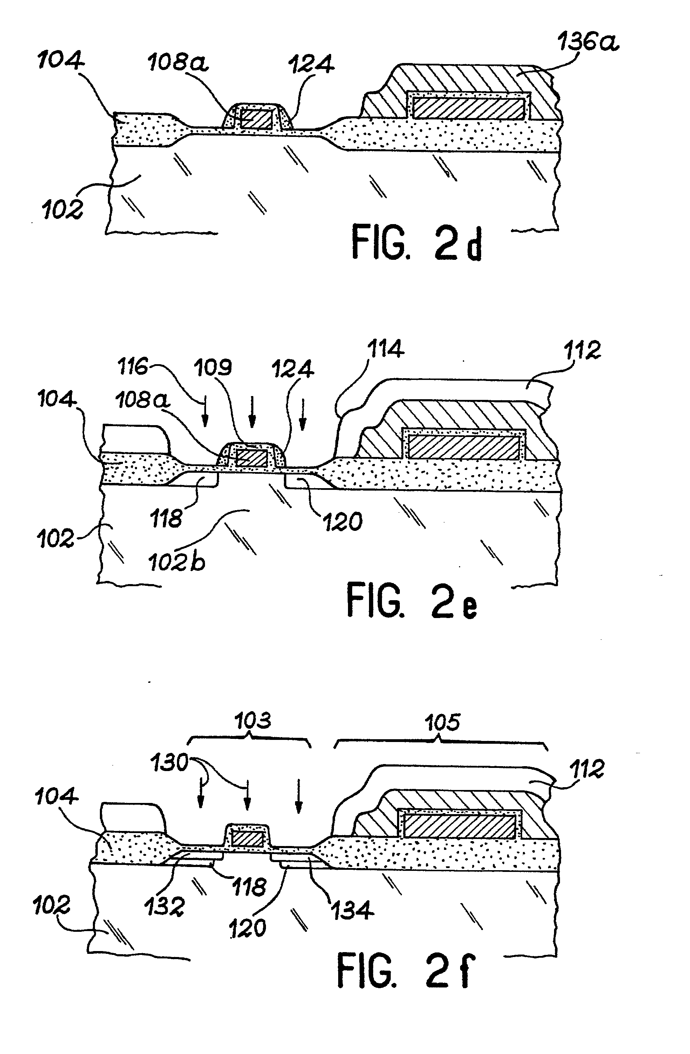

On effectue ensuite la gravure des régions de la couche de silicium 136 non recouvertes de résine. Cette gravure peut être réalisée en mode ionique réactif, anisotrope en utilisant comme agent de gravure un plasma d'hexafluorure de soufre ou par tout autre procédé de gravure sèche anisotropique. On obtient ainsi, de part et d'autre de la grille 108a isolée du transistor 103, des espaceurs 124 ainsi que la seconde électrode 136a du condensateur 105. La structure obtenue est représentée sur la figure 2d.

Les espaceurs 124 peuvent aussi être obtenus par gravure anisotropique du silicium polycristallin 136 au niveau des flancs de la grille 108a sans utiliser à ce niveau le masque 138. Ces espaceurs 124 sont des résidus volontaires qui résultent des surépaisseurs de silicium polycristallin sur les flancs des motifs de grille.

Après gravure de la couche 136, on élimine le masque de résine 138.

L'étape suivante du procédé, comme représenté sur la figure 2e, consiste à former un nouveau masque de résine 112 permettant de définir l'emplacement de la source et du drain du transistor à réaliser. En particulier, ce masque 112, réalisé par les techniques classiques de photolithographie, comporte une ouverture 114 située au-dessus de la région 102b du substrat dans laquelle sera réalisé le transistor.

On effectue alors une première implantation ionique 116 par exemple d'ions d'arsenic à une dose de $10^{15}$ à $10^{16}$ at/cm$^2$ avec une énergie de 180 keV. Cette implantation ionique 116 permet de former, de part et d'autre des espaceurs 124, deux régions respectivement 118 et 120 de type n$^+$ correspondant respectivement à la source et au drain du transistor. La source et le drain 118 et 120 présentent une épaisseur de l'ordre de 300 nm.

Dans le cas d'un substrat de type n, les ions implantés sont des ions de bore.

L'implantation ionique 116 est réalisée en utilisant la résine 112, les espaceurs 124 et la grille 108a du transistor revêtue de l'isolation 109 comme masque. Les espaceurs permettent d'éviter l'extension des régions 118 et 120 sous le canal du transistor (c'est-à-dire sous la grille 108a).

On effectue ensuite l'élimination (ou retrait) des espaceurs 124 par gravure plasma en mode isotropique, par exemple gravure ionique réactive en plasma d'hexafluorure de soufre à haute pression ou par tout autre procédé, sec ou humide, isotropique, surtout sélectif par rapport à la sous-couche d'oxyde de silicium 106 et par rapport à la résine de masquage 112. La structure obtenue est alors représentée sur la figure 2f.

Toujours à l'aide du masque 112, on réalise alors une seconde implantation d'ions 130 notamment d'arsenic servant à former deux régions 132 et 134 entourant respectivement la source 118 et le drain 120 du transistor réalisant ainsi les doubles jonctions du transistor. Ces régions 132 et 134 présentent la même conductivité que la source et le drain et en particulier une conductivité de type n.

L'implantation d'ions d'arsenic 130 peut être réalisée à une dose de l'ordre de $10^{13}$ at/cm$^2$ et à une énergie de 180 keV, ceci permet la pénétration des ions arsenic dans le substrat jusqu'à une profondeur de l'ordre de 100 nm.

Dans le cas d'un substrat de type n, les ions implantés sont des ions de bore.

L'étape suivante du procédé selon l'invention consiste à éliminer le masque de résine 112 en plasma d'oxygène suivi d'un bain de solution sulfo-oxygénée.

On effectue ensuite un recuit de la structure obtenue afin de permettre une diffusion des ions implantés ainsi qu'une guérison des défauts créés lors des deux implantations. Ce recuit peut être réalisé à une température de 1150°C pendant quelques heures (2 à 4 heures), sous atmosphère d'azote.

On dépose ensuite une couche d'isolant électrique, non représentée, par exemple en oxyde de silicium que l'on grave afin de former différents trous de contact électrique. On dépose ensuite sur cette couche isolante une couche conductrice généralement en aluminium que l'on grave afin de former les différentes connexions du circuit intégré.

La description donnée ci-dessus n'a bien entendu été donnée qu'à titre illustratif, toute modification, sans pour autant sortir du cadre de l'invention, peut être envisagée notamment en ce qui concerne la nature des couches, leur épaisseur, leur technique de dépôt et de gravure.

Le procédé selon l'invention grâce à un enchaînement d'étapes particulier permet de réduire le nombre d'étapes de celui-ci et en particulier le nombre d'étapes de masquage. Ceci est principalement lié à l'utilisation de la même couche conductrice pour former la seconde armature du condensateur et les espaceurs situés de part et d'autre de la grille du transistor à effet de champ, utilisés comme masque à l'implantation ionique pour former la source et le drain du transistor.

Ceci permet en outre la réalisation des deux dopages successifs du substrat pour former les doubles jonctions du transistor à l'aide du même masque de résine.

## Revendications

1. Procédé de fabrication d'un circuit intégré dans un substrat (102) semi-conducteur dopé, comprenant un transistor à effet de champ (103) à grille isolée, à doubles jonctions, formé dans une première région (102b) du substrat et une zone d'isolation électrique (104) formée dans une seconde région (102a) dudit substrat, adjacente à la première région, cette zone d'isolation (104) supportant un condensateur (105), le procédé étant caractérisé en ce qu'il comprend les étapes successives suivantes :

(a) - formation simultanée, dans une première couche conductrice (108), de la grille (108a) du transistor (103) et d'une première électrode (108b) du condensateur (105),

(b) - isolation électrique (109) simultanément de la grille (108a) et de la première électrode (108b),

(c) - formation simultanée, dans une seconde couche conductrice (136), d'espaceurs (124) sur les flancs isolés (109) de la grille (108a) et d'une seconde électrode (136a) du condensateur (105),

(d) - premier dopage de la première région (102b) du substrat pour former la source (118) et le drain (120) du transistor, les espaceurs (124) jouant le rôle de masque à ce premier dopage qui présente une conductivité inverse de celle du substrat (102),

(e) - élimination des espaceurs (124), et

(f) - second dopage de la première région (102b) du substrat pour former, autour de la source (118) et du drain (120), deux régions (132, 134) de conductivité inverse de celle du substrat (102).

2. Procédé de fabrication selon la revendication 1, caractérisé en ce que l'étape (d) consiste en ce qu'il comprend avant la realisation de l'étape (a) la formation de la zone d'isolation (104) dans la seconde région (102a) du substrat et d'un isolant de grille (106) dans la première région (102b) dudit substrat, à réaliser un masque (112) sur l'ensemble de la structure comportant une ouverture (114) en regard de la première région (102b) du substrat, — à effectuer une première implantation d'ions (116), à travers le masque, (112) pour former la source (118) et le drain (120) du transistor (103), les espaceurs (124) servant aussi de masque à cette implantation, — et en ce que l'étape (f) consiste — à effectuer une seconde implantation d'ions (130), à travers ledit masque, (112) pour former autour de la source (118) et du drain (120) deux régions (132, 134) de conductivité inverse de celle du substrat (102), et — à éliminer ledit masque (112).

3. Procédé de fabrication selon la revendication 1 ou 2, caractérisé en ce que la première couche (108) est réalisée en silicium polycristallin.

4. Procédé de fabrication selon la revendication 3, caractérisé en ce que l'isolation électrique (109) de la grille (108a) et de la première électrode (108b) est obtenue par oxydation thermique du silicium polycristallin constituant la première couche conductrice (108).

5. Procédé de fabrication selon la revendication 3, caractérisé en ce que le silicium polycristallin contient un dopant ayant une conductivité inverse de celle du substrat (102).

6. Procédé de fabrication selon l'une quelconqu des revendications 1 à 5, caractérisé en ce que la seconde couche conductrice (136) est réalisée en silicium polycristallin.

7. Procédé de fabrication selon l'une quelconque des revendications 1 à 6, caractérisé en ce que le substrat (102) étant du silicium de type p, les ions utilisés pour la première et la seconde implantations (116, 130) sont des ions d'arsenic.

8. Procédé de fabrication selon l'une quelconque des revendications 1 à 6, caractérisé en ce que le substrat (102) étant du silicium de type n, les ions utilisés pour la première et la seconde implantations (116, 130) sont des ions de bore.

9. Procédé de fabrication selon l'une quelconque des revendications 1 à 8, caractérisé en ce que l'étape a et/ou c consiste à déposer une couche conductrice (108, 136) et à effectuer, à travers un masque approprié (110, 138), une gravure anisotropique de cette couche.

10. Procédé de fabrication selon l'une quelconque des revendications 1 à 9, caractérisé en ce que l'isolant de grille (106) est de l'oxyde de silicium.

## Patentansprüche

1. Verfahren zur Herstellung einer integrierten Schaltung in einem dotierten Halbleitersubstrat mit einem Feldeffekttransistor (103) mit isoliertem Gate und doppelten Übergängen, der in einem ersten Bereich (102b) des Substrats geformt ist, und einer elektrischen Isolationszone (104), die in einem zweiten, an den ersten Bereich angrenzenden Bereich (102a) des Substrats geformt ist, wobei diese Isolationszone (104) einen Kondensator (105) trägt, wobei das Verfahren dadurch gekennzeichnet ist, daß es die folgenden sukzessiven Verfahrensschritte aufweist:

(a) das gleichzeitige Bilden des Gates (108a) des Transistors (103) und einer ersten Elektrode (108b) des Kondensators (105) in einer ersten leitfähigen Schicht,

(b) die gleichzeitige elektrische Isolierung (109) des Gates (108a) und der ersten Elektrode (108b),

(c) das gleichzeitige Bilden von Abstandsstücken (124) auf den isolierten Flanken (109) des Gates (108a) und einer zweiten Elektrode (136a) des Kondensators (105) In einer zweiten leitfähigen Schicht (136),

(d) ein erstes Dotieren des ersten Bereichs (102b) des Substrats, um die Source (118) und das Drain (120) des Transistors herzustellen, wobei die Abstandsstücke (124) die Rolle einer Maske für diese erste Dotierung spielt, die eine zu der Leitfähigkeit des Substrats (102) inverse Leitfähigkeit erzeugt,

(e) Entfernen der Abstandsstücke (124), und

(f) zweites Dotieren des ersten Bereichs (102b) des Substrats, um um die Source (118) und das Drain (120) zwei Bereiche (132, 134) mit einer zur Leitfähigkeit des Substrats (102) inversen Leitfähigkeit zu erzeugen.

2. Herstellungsverfahren nach Anspruch 1, dadurch gekennzeichnet, daß der Verfahrensschritt (d) darin besteht, daß er vor der Durchführung des Verfahrensschritts (a) die Bildung der Isolationszone (104) im zweiten Bereich (102a) des Substrats und einer Gateisolation (106) im ersten Bereich (102b) des Substrats umfaßt, eine Maske (112) auf der Gesamtheit der Struktur mit einer Öffnung (114) gegenüber dem ersten Bereich (102b) des Substrats auszuführen, eine erste Ionenimplantation (116) durch die Maske (112) zum Bilden der Source (118) und des Drains (120) des Transistors (103) durchzuführen, wobei die Abstandsstücke (124) ebenfalls als Maske für diese Implantation dienen, und daß der Verfahrensschritt (f) darin besteht, eine zweite Ionenimplantation (130) durch die Maske (112) durchzuführen, um um die Source (118) und das Drain (120) zwei Bereiche (132, 134) mit einer zur Leitfähigkeit des Substrats (102) inversen Leitfähigkeit zu erzeugen, und die Maske (112) zu entfernen.

3. Herstellungsverfahren nach Anspruch 1 oder 2, dadurch gekennzeichnet, daß die erste Schicht (108) aus polykristallinem Silizium besteht.

4. Herstellungsverfahren nach Anspruch 3, dadurch gekennzeichnet, daß die elektrische Isolierung (109) des Gates (108a) und der ersten Elektrode (108b) durch thermische Oxydation des polykristallinen Siliziums erhalten wird, das die erste leitfähige Schicht (108) bildet.

5. Herstellungsverfahren nach Anspruch 3, dadurch gekennzeichnet, daß das polykristalline Silizium einen Dotierstoff mit einer zur Leitfähigkeit des Substrats (102) inversen Leitfähigkeit enthält.

6. Herstellungsverfahren nach einem der Ansprüche 1 bis 5, dadurch gekennzeichnet, daß die zweite leitfähige Schicht (136) aus polykristallinem Silizium besteht.

7. Herstellungsverfahren nach einem der Ansprüche 1 bis 6, dadurch gekennzeichnet, daß das Substrat (102) aus p-Typ Silizium besteht und die für die erste und zweite Implantation (116, 130) verwendeten Ionen Arsenionen sind.

8. Herstellungsverfahren nach einem der Ansprüche 1 bis 6, dadurch gekennzeichnet, daß das Substrat (102) aus n-Typ Silizium besteht und die für die erste und zweite Implantation (116, 130) verwendeten Ionen Borionen sind.

9. Herstellungsverfahren nach einem der Ansprüche 1 bis 8, dadurch gekennzeichnet, daß der Verfahrensschritt a und/oder c darin besteht, eine leitfähige Schicht (108, 13b) abzuscheiden und durch eine geeignete Maske (110, 138) eine anisotrope Ätzung dieser Schicht durchzuführen.

10. Herstellungsverfahren nach einem der Ansprüche 1 bis 9, dadurch gekennzeichnet, daß die Gateisolierung (106) aus Siliziumoxyd besteht.

**Claims**

1. Process for manufacturing a circuit integrated in a semi-conducting, doped substrate (102), including a transistor with field effect (103) with insulated grid with double connectors, formed in a first region (102b) of the substrate and an electric insulation zone (104) formed in a second region (102a) of said substrate, adjacent to the first region, this insulation zone (104) bearing a condenser (105), the process being characterized in that it comprises the following successive stages:

(a) – simultaneous formation, in a first conducting layer (108), of the grid (108a) of the transistor (103) and of a first electrode (108b) of the condenser (105),

(b) – electric insulation (109) simultaneously of the grid (108a) and of the first electrode (108b),

(c) – simultaneous formation, in a second conducting layer (136), of spacers (124) on the insulated sides (109) of the grid (108a) and of a second electrode (136a) of the condenser (105),

(d) – first doping of the first region (102b) of the substrate to form the source (118) and the drain (120) of the transistor, the spacers (124) playing the rôle of mask at this first doping which has a conductivity opposite that of the substrate (102),

(e) – elimination of the spacers (124), and

(f) – second doping of the first region (102b) of the substrate to form, around the source (118) and the drain (120), two regions (132, 134) with conductivity opposite that of the substrate (102).

2. Manufacturing process according to Claim 1, characterized in that stage (d), prior to realization of stage (a), consists of the formation of the insulation zone (104) in the second region (102a) of the substrate and of a grid insulator (106) in the first region (102b) or said substrate, realizing a mask (112) on the whole of the structure comprising an opening (114) opposite the first region (102b) of the substrate, effecting a first implantation of ions (116), through the mask (112) to form the source (118) and the drain (120) of the transistor (103), the spacers (124) serving also as mask to this implantation, and that stage (f) consists of effecting a second implantation of ions (130), through said mask (112) to form around the source (118) and the drain (120) two regions (132, 134) with conductivity opposite that of the substrate (102), and of eliminating said mask (112).

3. Manufacturing process according to Claim 1 or 2, characterized in that the first layer (108) is made of polycrystalline silicon.

4. Manufacturing process according to Claim 3, characterized in that the electric insulation (109) of the grid (108a) and of the first electrode (108b) is obtained by thermal oxidation of the polycrystalline silicon constituting the first conducting layer (108).

5. Manufacturing process according to Claim 3, characterized in that the polycrystalline silicon contains a dope having a conductivity opposite that of the substrate (102).

6. Manufacturing process according to any of Claims 1 to 5, characterized in that the second conducting layer (136) is made of polycrystalline silicon.

7. Manufacturing process according to any of Claims 1 to 6, characterized in that the substrate (102) being of silicon of type p, the ions used for the first and second implantations (116, 130) are arsenic ions.

8. Manufacturing process according to any of Claims 1 to 6, characterized in that the substrate (102) being of silicon of type n, the ions used for the first and second implantations (116, 130) are boron ions.

9. Manufacturing process according to any of Claims 1 to 5, characterized in that stage a and/or c consists of depositing a conducting layer (108, 136) and of carrying out, through an appropriate mask (110, 138), an anisotropic engraving of this layer.

10. Manufacturing process according to any of Claims 1 to 9, characterized in that the grid insulator (106) is of silicon oxide.

FIG. 1a

FIG. 1b

FIG. 1c

FIG. 1d

FIG. 1e

FIG. 1f

FIG. 1g

FIG. 1h

FIG. 2a

FIG. 2b

FIG. 2c

FIG. 2 d

FIG. 2 e

FIG. 2 f